# EUROPEAN PATENT SPECIFICATION

(11) **EP 0 786 199 B1**
(45) Date of publication and mention of the grant of the patent: **26.03.2003**
(21) Application number: 95934943.2
(22) Date of filing: 12.10.1995
(51) Int. Cl.: H05K 13/08

(54) **REPRODUCTION OF COMPONENTS**
BAUTEILE-BILDWIEDERGABE
REPRODUCTION D'IMAGES DE COMPOSANTS

(30) Priority: 12.10.1994 SE 9403478
(43) Date of publication of application: 30.07.1997
(73) Proprietor: Mydata Automation AB, 168 66 Bromma (SE)
(72) Inventor: JACOBSSON, Nils, S-175 63 Järfälla (SE)
(74) Representative: Rosenquist, Per Olof
(86) International application number: SE9501178
(87) International publication number: WO96012396

(56) References cited:
- EP-A- 0 330 294
- EP-A- 0 374 848
- EP-A- 0 471 272
- EP-A- 0 577 080
- EP-A- 0 596 533

## Description

### TECHNICAL FIELD

The present invention relates to a simultaneous reproduction of a number of components, in particular components retained by a line of pickup devices in a component assembly machine, in particular an assembly machine for the automatic mounting of electronic and similar components.

### BACKGROUND

Automatic assembly machines for electronic components conventionally have a pickup head, which fetches electronic components from different magazines and puts them on accurately determined locations on a circuit board. The pickup head can have a number of individual pickup devices or sucking pipettes whereby in a pick-up movement of the pickup head several components are fetched, so that after the pickup operation, the pickup head carries several components at the same time. For the accurate positioning of the components, automatic image processing can be used and then an image of all the simultaneously retained components is captured, when the pickup head and all its separate pickup devices, at which the components are retained, adopt an accurately predetermined reference position. The sucking nozzles of the pickup devices are then located in a row and thus the components are also generally retained in positions along a line. During image capturing, image fields or fields of view are conventionally used, which are generally rectangular and have dimensions, which do not differ too much from a quadratic shape, for instance having a ratio of normally 4:3 between the long and short sides of the image field at most. When components are reproduced by means of a device having such an image field, it will be possibly to use, in the image processing, only the central horizontal part of the image, parallel to the long sides of the image field, what provides a poor utilization of the captured image. In other words, when using an image processing device having discrete light sensitive elements such as a CCD-camera, only a few pixel points of the captured image will be used during the image processing, most of the pixel points being totally irrelevant for the information, which is to be extracted.

Conventional methods of capturing an image of a single component during automatic or electronic image processing can comprise one of the following:
- 1. Placing the component in front of a camera, in order to obtain one whole single image of the component.
- 2. Capturing two images and placing the component in such a way that one half of the component at a time is reproduced by the camera. Subsequently the two images are put together by an image processing routine. The two half images show the component in the same scale.
- 3. Capturing four images, each of which showing one of the four corners of the components, by placing the component at a suitable lateral location, but at the same distance from the camera. Thereafter the images are put together by an image processing routine. The four images are captured in the same scale.

The use of lens systems producing distorted pictures has also been suggested in association with mounting electronic components, see U.S. patent US-A 5,249,239 and the Japanese patent application JP-A 63-122300. Typical distorting lens systems are also disclosed in U.S. patent US-A 4,158,134 and the Japanese patent application JP-A 57-204018.

### SUMMARY

It is an object of the invention to provide a method and a device for capturing an image of several components placed in a row, having a good resolution of each reproduced component.

It is a further object of the invention to provide an automatic component assembly machine having an accurate reproduction of several simultaneously retained components, having in particular a good angular resolution to be used by an image processing system during the positioning of the components. These objects are achieved by the invention, the characteristics of which are set out in and the scope of which is defined by the appended claims.

For the reproduction, a lens system may be used having different magnification in suitable directions perpendicular to each other.

According to a preferred embodiment of the invention, a pickup head for an automatic component assembly machine comprises several pipettes located next to each other for retaining components at the sucking nozzles of the pipettes at their lower ends. The pipettes are located in the same plane, the separate components thus having their midpoints along an approximately straight line. In the reproduction of the components for an accurate evaluation of their positions in relation to the pipettes, a reproduction system is used, having a larger magnification in a direction perpendicular to the approximately straight line through the components than parallel thereto. The reproductions of the individual components become hereby extended perpendicularly to the line through the components. This provides a better utilization of the image points during the evaluation of a captured image, which can be captured by the light sensitive surface of a video camera for digital processing. A more accurate determination of the positions of the components can hereby be made.

Thus, components retained in a row of retaining devices are generally reproduced for an automatic evaluation of the positions of the components, by capturing an image of the components by means of an image capturing device, which has a larger magnification in a direction perpendicular to the component row than parallel to the component row. For this purpose an image capturing device is arranged in front of or underneath the components, when they in one case pass the image capturing device or when they in a second case stop to remain in a reference position of the retaining devices. The image capturing device then presents a larger magnification in a direction perpendicular to the component row than parallel to the component row. The retaining devices are located on a pickup head, which in the first case can comprise an indication or reference surface stiffly mounted at the pickup head, placed in such a way that it is at least partly located inside of the field of view of the image capturing device during the capture an image of the components.

### BRIEF DESCRIPTION OF THE DRAWINGS

The invention will now be described by way of a non-limiting embodiment with reference to the accompanying drawings, in which.
- Figure 1 is a schematic perspective view of parts of a pickup head for an automatic component assembly machine, having schematically shown optical devices for capturing an image of retained components,
- Figure 2 is an image of the retained components captured by conventional optical devices,
- Figure 3 is an image of the retained components captured by specially designed optical devices and
- Figure 4 is a perspective view of a component assembly device.

### DETAILED DESCRIPTION

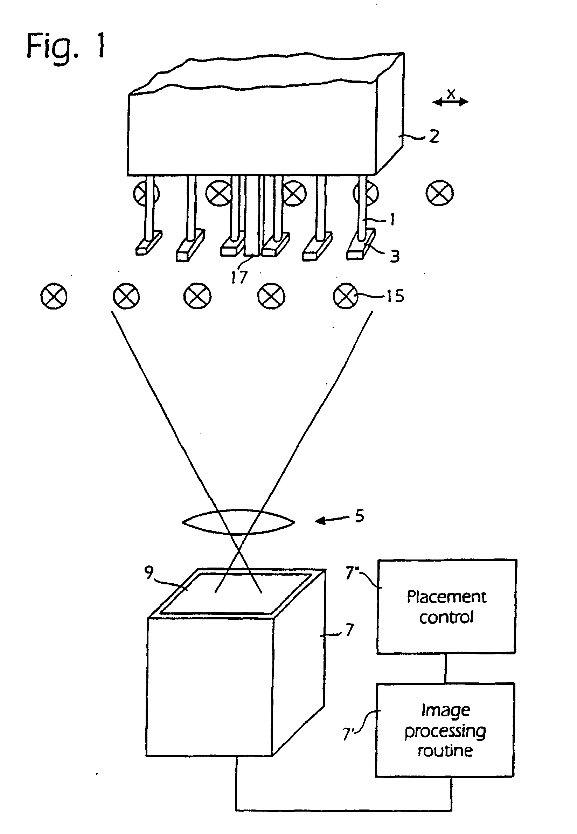

In the upper part of Figure 1 the lower portions of pickup devices or pipettes 1 are shown, belonging to a component pickup and placement head 2 of an automatic assembly machine for electronic components. The pipettes 1 are arranged in parallel to each other at an equal spacing and retain components 3 at their lower ends, where sucking nozzles are located. The pickup head 2 is placed on an x-wagon, which is moveable in a lateral direction, the x-direction.

An image capturing system, comprising a lens arrangement 5 and a video camera 7 having a light sensitive surface 9 comprising an array of CCD-elements is placed underneath the path, along which the components 3 pass from a pickup place to a placement location, and it can capture an image from underneath of the components, when they are in a suitable position. The image captured by the video camera 7 is communicated to an image evaluation device 7', where a determination of the positions of the components is made, the result of the determination being then transferred to a control unit 7" arranged to control the movement of the pickup head 2 and the movement of the individual pipettes 3 in relation thereto.

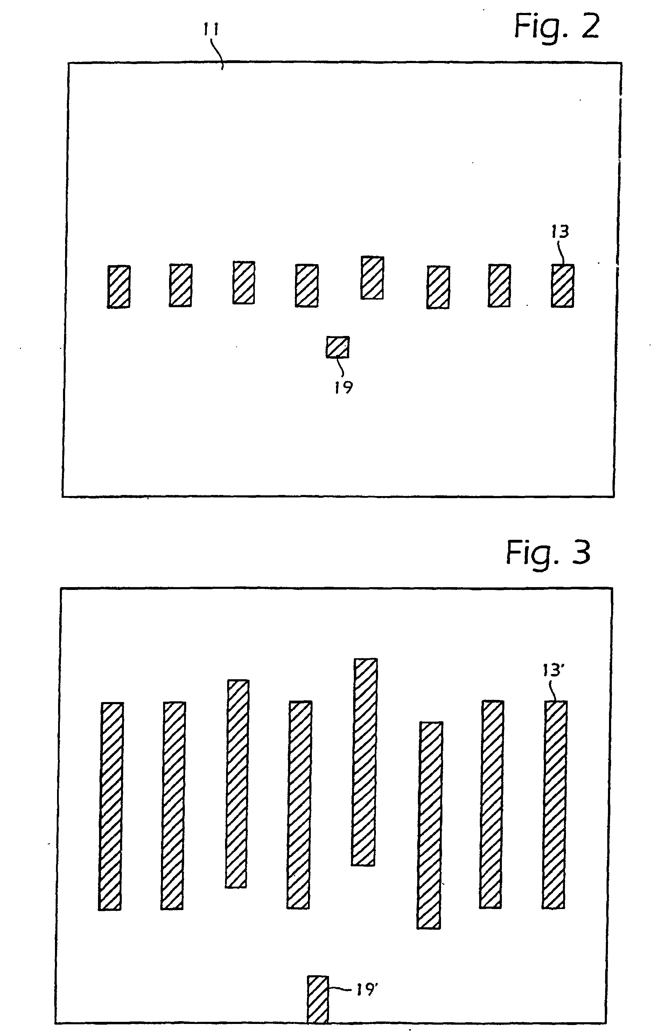

The image obtained by means of a conventional lens system 5, is schematically shown in Figure 2 as a rectangular image field 11 and individual pictures 13 of the components 3 therein. The pictures 13 are located along a row in an approximately straight line, for a typical adjustment of the system in the middle of the image field 11, the center lines of the component pictures extending in parallel to the long side of the image field. Owing to the arrangement along a line of the components 3 and hereby of their pictures 13, only the central portion of the image field, where the individual pictures are found, is normally used, at least if the components 3 are not too elongated, and thereby information only needs to be taken from this area during an automatic image processing of the signals from the light sensitive elements of the surface 9. The information from other light sensitive elements is not used since they do not contain any information.

Instead, as a lens arrangement 5 in front of the video camera 7 a nonlinear lens system having different magnifications in different directions can be used. This can be obtained by means of specially calculated lens devices, compare e.g. the above cited patent applications and patents, which are incorporated herein by reference. Such a lens system is then adjusted so that a maximal magnification is obtained perpendicularly to a straight line passing approximately through the centers of the individual pictures 13 according to Figure 2, a smaller magnification being set in a direction parallel to that line. The image obtained in that way can become as is schematically illustrated in Figure 3. The obtained separate pictures 13' of each component within the image field 11 are then elongated in a direction perpendicular to the straight line through the centers of the individual component pictures and thus also to the sides of the image field 11, in the preferred case to the long sides. These pictures can occupy a large portion of the image field 11, so that considerably more light sensitive elements of the light sensitive surface of 9 of the video camera 11 can be used by an automatic image evaluation system.

A higher accuracy is hereby obtained, primarily of the angular positions of the individual components, i.e. the rotated positions thereof in relation to some initial position, which for instance is the position in which their long sides are located perpendicular to said line, by obtaining a longer side of the reproductions 13' in a transverse direction, perpendicularly to the line. There is also a better accuracy in the determination of the positions of the components in a transverse direction since deviations from the centre line are enlarged by the optical devices. One can also obtain a better accuracy in a longitudinal direction, parallel to the central line, since there are more individual picture elements which indicate the position of the outer sides in the transverse directions, which results in a better statistical significance.

The anisotropical optical system 5 can produce some distortions in the obtained image, that is it can become distorted compared to the ideal image, which is illustrated Figure 3. In particular at the corners of the image field, reproduction errors can occur and also generally in areas next to the sides of the image field 11. However, this effect is not disturbing, since a calibration of the image field can be made easily by placing a calibration plate having some regular known pattern, for instance dots placed in a quadratic lattice or a square pattern, in the area, which is projected on the light sensitive surface 9 of camera 7.

According to a first embodiment all the pipettes 1 and the pickup head 2 are assumed to be located in a reference position, during the capturing of the image of the component 3, for which position the positions of the pipettes and the pickup head are accurately determined and known. According to a second embodiment the image can instead be captured, when the pickup head and its parts pass continuously over the reproduction system. The elements of the light sensitive 9 of the camera 7 are then activated only during a very short time in order to capture an image of the component 3, which is equivalent to opening the shutter of a conventional camera for very short time. This might require extra illumination of the components in this position, and lamps 15 can be arranged on both sides of the path of the components 3.

In this case there is no given reference position, to which the fixedly set reproduction system and its evaluation circuits for the captured image can relate the positions of the components 3. Therefor, a reference can be arranged in the captured image itself by attaching stiffly to the pickup head 2 a reference projection 17, which extends in parallel to the longitudinal direction of the pipettes 3 and which has a lower surface, which is located in approximately the same plane as the bottom side of the components 3 or can even be allowed to be located at a distance behind this plane, as seen from the video camera 7. For a suitable location of the under surface of the projection 17 it will be reproduced in the captured image field, as indicated at 19 in Figure 2 and at 19' in Figure 3. If the pipettes 1 with their lower surfaces only project a small distance beyond the bottom surface of the pickup head 2, instead of a reference projection equivalently a reference mark attached to this very bottom surface can be used.

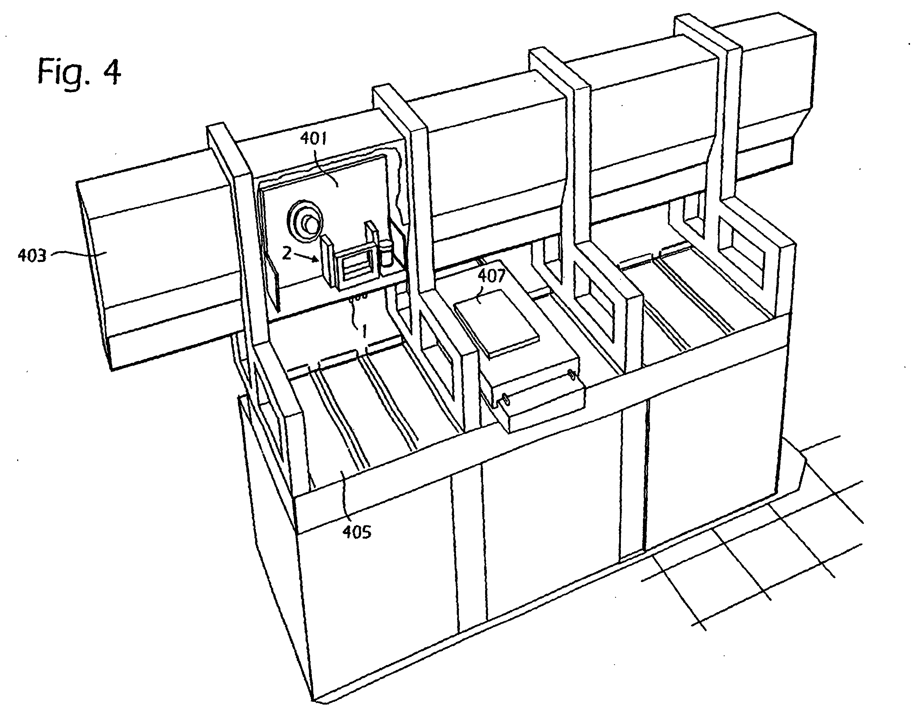

In Figure 4 a component assembly or pick-and-place machine is illustrated in a perspective view showing the general configuration of such a machine. A wagon 401 is movable along a horizontal bar 403, in the x-direction, to different locations, such as above magazine sites 405 intended to hold component feeders, which are movable in a horizontal direction, the y-direction, perpendicular to the guide bar 403 and above a circuit board 407 retained on a slide, also movable in the same direction as the magazine sites 405. The wagon 401 carries a pickup unit or head 2, from the lower side of which the vacuum pipettes 1 protrude downwards. The optical reproduction system including the video camera 7 can be located on one of the magazine sites 405 or at the x-wagon 401 itself, if suitable mirrors are placed in the paths of the light rays.

## Claims

1. A method of reproducing components (3), which are retained in a row or a line, for an automatic evaluation of the positions of the components (3), wherein an image of the components (3) is captured by means of an image capturing device (5, 7, 9), **characterised in that** the image of the components captured by the image capturing device (5, 7, 9), has a larger magnification in a direction perpendicular to the row or line of components (3) than in parallel to that row or line.

2. An arrangement for reproducing components (3), which are retained in a row or a line, for an automatic evaluation of the positions of the components, comprising an image capturing device (5, 7, 9) for capturing an image of the components (3), **characterised in that** the image capturing device (5, 7, 9) is arranged to provide a larger magnification in a direction perpendicular to the row or line of components (3) than in parallel to that row or line.

3. An arrangement according to claim 2, **characterised in that** the image capturing device (5, 7, 9) is arranged in front of or underneath the row of components (3) when the components (3) are located at or pass the arrangement.

4. An arrangement according to claim 2, wherein the components (3) are retained in the row by retaining devices (1), **characterised in that** the image capturing device (5, 7, 9) is arranged in front of or underneath the row or line of components (3), when the components (3) are in a reference position of the retaining devices (1).

5. A component assembly machine comprising a pickup head (2) having retaining devices (1) for retaining components (3) along an essentially straight row or line, and further having an arrangement for automatic evaluation of the positions of the components (3), the arrangement comprising an image capturing device (5, 7, 9) for capturing an image of the components (3), **characterised in that** the image capturing device (5, 7, 9) is arranged to provide a larger magnification in a direction perpendicular to the straight row or line of components (3) than in parallel to that row or line.

6. A component assembly machine according to claim 5, **characterised in that** the image capturing device (5, 7, 9) is arranged in front of or underneath the components (3) when the retaining devices (1) in the pickup head (2) are located at or pass the image capturing device (5, 7, 9).

7. A component assembly machine according to claim 5, **characterised in that** the retaining devices (1) can adopt a reference position with the components (3) placed along an essentially straight line, and that the image capturing device (5, 7, 9) is arranged in front of or underneath the components (3) when the retaining devices (1) are in the reference position.

8. A component assembly machine according to any one of claims 5 - 7, **characterised in that** the pickup head (2) comprises an indication or reference surface stiffly attached thereto, the indication or reference surface being placed in such a manner that it is at least partly located inside the image field (11) or field of view of the image capturing device (5, 7, 9) in capturing an image of the components (3).

## Patentansprüche

1. Verfahren für die Bildwiedergabe von Bauteilen (3), die in einer Reihe oder Linie gehalten werden, für eine automatische Ermittlung der Positionen der Bauteile (3), wobei eine Abbildung der Bauteile (3) mit Hilfe einer Bilderfassungsvorrichtung (5, 7, 9) erfaßt werden, **dadurch gekennzeichnet, daß** die Abbildung der Bauteile, die durch die Bilderfassungsvorrichtung (5, 7, 9) erfaßt wird, eine stärkere Vergrößerung in einer Richtung senkrecht zur Reihe oder Linie der Bauteile (3) hat als parallel zu dieser Reihe oder Linie.

2. Anordnung zum Reproduzieren von Bauteilen (3), die in einer Reihe oder Linie gehalten werden, für eine automatische Ermittlung der Positionen der Bauteile, enthaltend eine Bilderfassungsvorrichtung (5, 7, 9) zum Erfassen einer Abbildung der Bauteile (3), **dadurch gekennzeichnet, daß** die Bilderfassungsvorrichtung (5, 7, 9) so angeordnet ist, daß sie in einer Richtung senkrecht zur Reihe oder Linie der Bauteile (3) ein stärkere Vergrößerung erzeugt als parallel zu dieser Reihe oder Linie.

3. Anordnung nach Anspruch 2, **dadurch gekennzeichnet, daß** die Bilderfassungsvorrichtung (5, 7, 9) vor oder unter der Reihe von Bauteilen (3) angeordnet ist, wenn sich die Bauteile (3) an der Anordnung befinden, oder diese passieren.

4. Anordnung nach Anspruch 2, bei der die Bauteile (3) in der Reihe durch Haltevorrichtungen (1) gehalten werden, **dadurch gekennzeichnet, daß** die Bilderfassungsvorrichtung (5, 7, 9) vor oder unter der Reihe oder Linie der Bauteile (3) angeordnet ist, wenn sich die Bauteile (3) in einer Referenzposition der Hattevorrichtungen (1) befinden.

5. Bauteilanordnungsmaschine, enthaltend eine Aufnahmekopf (2), der über Haltevorrichtungen (1) zum Halten der Bauteile (3) entlang einer im wesentlichen geraden Reihe oder Linie verfügt, und weiterhin enthaltend eine Anordnung zum automatischen Ermitteln der Positionen der Bauteile (3), wobei die Anordnung eine Bilderfassungsvorrichtung (5, 7, 9) zum Erfassen einer Abbildung der Bauteile (3) enthält, **dadurch gekennzeichnet, daß** die Bilderfassungsvorrichtung (5, 7, 9) so angeordnet ist, daß sie eine stärkere Vergrößerung senkrecht zur geraden Reihe oder Linie der Bauteile (3) erzeugt als parallel zu dieser Reihe oder Linie.

6. Bauteilanordnungsmaschine nach Anspruch 5, **dadurch gekennzeichnet, daß** die Bilderfassungsvorrichtung (5, 7, 9) vor oder unter den Bauteilen (3) angeordnet ist, wenn sich die Haltevorrichtungen (1) im Aufnahmekopf (2) an der Bilderfassungsvorrichtung (5, 7, 9) befinden oder diese passieren.

7. Bauteilanordnungsmaschine nach Anspruch 5, **dadurch gekennzeichnet, daß** die Haltevorrichtungen (1) eine Referenzposition mit den Bauteilen (3) einnehmen können, die entlang einer im wesentlichen geraden Linie angeordnet sind, und daß die Bilderfassungsvorrichtung (5, 7, 9) vor oder unter den Bauteilen (3) angeordnet ist, wenn sich die Haltevorrichtungen (1) in einer Referenzposition befinden.

8. Bauteilanordnungsmaschine nach einem der Ansprüche 5-7, **dadurch gekennzeichnet, daß** der Aufnahmekopf (2) eine Markierungs- oder Referenzfläche enthält, die an ihm steif angebracht ist, wobei diese Markierungs- oder Referenzfläche derart angeordnet ist, daß sie sich wenigstens teilweise im Bildfeld (11) oder Sichtfeld der Bilderfassungsvorrichtung (5, 7, 9) beim Erfassen einer Abbildung der Bauteile (3) befindet.

## Revendications

1. Procédé de reproduction de composants (3) qui sont maintenus dans une rangée ou une ligne, pour une évaluation automatique des positions des composants (3), dans lequel une Image des composants (3) est capturée au moyen d'un dispositif de capture d'images (5, 7, 9), **caractérisé en ce que** l'image des composants capturée par le dispositif de capture d'images (5, 7, 9) a un plus fort grossissement dans une direction perpendiculaire à la rangée ou ligne de composants (3) que parallèlement à cette rangée ou ligne.

2. Equipement pour reproduire des composants (3) qul sont maintenus dans une rangée ou une ligne, pour une évaluation automatique des positions des composants, comprenant un dispositif de capture d'images (5, 7, 9) pour capturer une image des composants (3), **caractérisé en ce que** le dispositif de capture d'images (5, 7, 9) est disposé pour donner un plus fort grossissement dans une direction perpendiculaire à la rangée ou ligne de composants (3) que parallèlement à cette rangée ou ligne.

3. Équipement selon la revendication 2, **caractérisé en ce que** le dispositif de capture d'images (5, 7, 9) est disposé en face ou au-dessous de la rangée de composants (3) lorsque les composants (3) sont situés au niveau de l'équipement ou passent devant.

4. Equipement selon la revendication 2, dans lequel les composants sont maintenus dans la rangée par des dispositifs de maintien (1), **caractérisé en ce que** le dispositif de capture d'images (5, 7, 9) est disposé en face ou au-dessous de la rangée de composants (3) lorsque les composants (3) sont dans une position de référence des dispositifs de maintien (1).

5. Machine d'assemblage de composants comprenant une tête de ramassage (2) dotée de dispositifs de maintien (1) pour maintenir les composants (3) le long d'une rangée ou ligne essentiellement droite, et possédant en outre un dispositif pour l'évaluation automatique des positions des composants (3), le dispositif comprenant un dispositif de capture d'images (5, 7, 9) pour capturer une image des composants (3), **caractérisée en ce que** le dispositif de caplure d'images (5, 7, 9) est disposé pour donner un plus fort grossissement dans une direction perpendiculaire à la rangée ou ligne de composants (3) que parallèlement à cette rangée ou ligne.

6. Machine d'assemblage de composants selon la revendication 5, **caractérisée en ce que** le dispositif de capture d'images (5, 7, 9) est disposé en face ou au-dessous des composants (3) lorsque les dispositifs de maintien (1) de la tête de ramassage (2) sont situés au niveau du dispositif de capture d'images (5, 7, 9) ou passent devant.

7. Machine d'assemblage de composants selon la revendication 5. **caractérisée en ce que** les dispositifs de maintien (1) peuvent adopter une position de référence avec les composants (3) placés le long d'une ligne essenticllement droite, et que le dispositif de capture d'images (5, 7, 9) est disposé en face ou au-dessous des composants (3) lorsque les dispositifs de maintien sont dans la position de référence.

8. Machine d'assemblage de composants selon l'une quelconque des revendications 5 à 7, **caractérisée en ce que** la tête de ramassage (2) comprend une surface d'indication ou de référence fixée de manière rigide sur elle, la surface d'indication ou de référence étant placée de telle manière qu'elle est au moins partiellement située dans le champ de l'image (11) ou le champ de vision du dispositif de capture d'images (5, 7, 9) lors de la capture d'une image des composants (3)
